# EUROPEAN PATENT APPLICATION

(11) **EP 4 848 359 A1**
(43) Date of publication of application: **02.12.2026**
(21) Application number: 24921373.7
(22) Date of filing: 16.08.2024
(51) Int. Cl.: H01M 4/36, H01M 10/0525

(54) **SILICON-CARBON COMPOSITE MATERIAL AND PREPARATION METHOD THEREFOR, AND SECONDARY BATTERY AND ELECTRIC APPARATUS**

(30) Priority: 29.01.2024 CN 202410122765
(71) Applicant: Contemporary Amperex Technology Co., Limited, Ningde, Fujian 352100 (CN)
(72) Inventor: XIE, Shuai, Ningde, Fujian 352100 (CN); WANG, Jiazheng, Ningde, Fujian 352100 (CN); LIU, Liangbin, Ningde, Fujian 352100 (CN); LYU, Zijian, Ningde, Fujian 352100 (CN); CHEN, Wenqiang, Ningde, Fujian 352100 (CN); DENG, Jingxian, Ningde, Fujian 352100 (CN); SU, Yingwei, Ningde, Fujian 352100 (CN); GUO, Xiaoxin, Ningde, Fujian 352100 (CN)
(74) Representative: Gong, Jinping
(86) International application number: PCT/CN2024/112790
(87) International publication number: WO 2025/161347

(57) **Abstract**

A silicon-carbon composite material and preparation method thereof, a secondary battery, and an electric apparatus are provided. The silicon-carbon composite material includes a porous carbon matrix and a silicon-based material, where at least part of the silicon-based material is distributed in pores of the porous carbon matrix; and the silicon-carbon composite material satisfies Q2/Q1 ≤ 0.7, a button cell containing the silicon-carbon composite material is charged and discharged, a capacity corresponding to a voltage of 0.2 V to 0.4 V during charging is Q1, and a capacity corresponding to a voltage of 0.4 V to 0.6 V during charging is Q2.

## Description

### CROSS-REFERENCE TO RELATED APPLICATIONS

This disclosure is based on the Chinese patent application with application number 202410122765.6, filed on January 29, 2024 and entitled "SILICON-CARBON COMPOSITE MATERIAL AND PREPARATION METHOD THEREOF, SECONDARY BATTERY, AND ELECTRIC APPARATUS", and claims the priority of the Chinese patent application, the entire content of which is incorporated into this disclosure by reference.

### TECHNICAL FIELD

This disclosure relates to the field of battery technology, and in particular, to a silicon-carbon composite material and preparation method thereof, a secondary battery, and an electric apparatus.

### BACKGROUND

In recent years, with the application range of secondary batteries becoming increasingly widespread, secondary batteries are widely used in energy storage power systems such as hydropower, thermal power, wind power, and solar power stations, as well as in multiple fields such as electric tools, electric bicycles, electric motorcycles, electric vehicles, military equipment, and aerospace. Since secondary batteries have achieved great development, higher requirements have also been placed on their performance and the like.

Silicon-carbon composite materials are typically used as negative electrode active materials for secondary batteries and have an important influence on the performance of secondary batteries. However, in current secondary batteries, the performance of negative electrode active materials still cannot meet the demand for high cycling performance of secondary batteries.

### SUMMARY

This disclosure is conducted in view of the above problems, with an objective of providing a silicon-carbon composite material capable of improving the cycling performance of secondary batteries and a preparation method thereof. Additionally, this disclosure further provides a secondary battery including the above silicon-carbon composite and an electric apparatus including the above secondary battery.

To achieve the above objective, this disclosure provides a silicon-carbon composite material and preparation method thereof, a secondary battery, and an electric apparatus.

According to a first aspect, this disclosure provides a silicon-carbon composite material, where the silicon-carbon composite material includes:
a porous carbon matrix and a silicon-based material, where at least part of the silicon-based material is distributed in pores of the porous carbon matrix; and
the silicon-carbon composite material satisfies Q2/Q1 ≤ 0.7, a button cell containing the silicon-carbon composite material is charged and discharged, a capacity corresponding to a voltage of 0.2 V to 0.4 V during charging is Q1, and a capacity corresponding to a voltage of 0.4 V to 0.6 V during charging is Q2.

The silicon-carbon composite material in this disclosure satisfies Q2/Q1 ≤ 0.7, which reflects that most of the silicon-based material is deposited in the pores of the porous carbon matrix, with only a small amount of silicon-based material deposited on the surface of the porous carbon matrix, effectively improving the cycling performance of the secondary battery.

In some embodiments, the silicon-carbon composite material satisfies 0.3 ≤ Q2/Q1 ≤ 0.7. In some embodiments, the silicon-carbon composite material satisfies 0.5 ≤ Q2/Q1 ≤ 0.65.

In some embodiments, at least part of the surface of the silicon-carbon composite material has a coating; and optionally, a thickness of the coating is 2 nm to 100 nm.

The surface of the silicon-carbon composite material of this disclosure has a coating, which can reduce side reactions between the material surface and the electrolyte, thereby improving the initial coulombic efficiency of the secondary battery.

In some embodiments, the silicon-carbon composite material satisfies Q3/Q1 ≤ 0.37; where a capacity corresponding to a voltage of 0.6 V to 0.8 V during charging is Q3.

Thus, the silicon-carbon composite material of this disclosure satisfies Q3/Q1 ≤ 0.37, which can effectively improve the initial coulombic efficiency of the secondary battery.

In some embodiments, the silicon-carbon composite material satisfies 0.25 ≤ Q3/Q1 ≤ 0.37. In some embodiments, the silicon-carbon composite material satisfies 0.3 ≤ Q3/Q1 ≤ 0.37.

In some embodiments, the porous carbon matrix includes micropores and mesopores. In some embodiments, a pore volume ratio of the micropores to the mesopores is 1 to 40. In some embodiments, a pore volume ratio of the micropores to the mesopores is 3 to 10.

In some embodiments, the silicon-carbon composite material satisfies at least one of the following:
a specific surface area BET of the silicon-carbon composite material is 0.1 m²/g to 5 m²/g, and is, in some embodiments, 1 m²/g to 3 m²/g;
a percentage of the silicon-based material in the silicon-carbon composite material is 30% to 60%, and is, in some embodiments, 40% to 50%; and
at least part of the silicon-based material in the silicon-carbon composite material exists in a form of amorphous silicon.

According to a second aspect, this disclosure provides a preparation method of a silicon-carbon composite material, the method including the following steps:
introducing a gas containing silane into a reactor including a porous carbon matrix to deposit a silicon-based material in pores of the porous carbon matrix; and
monitoring reaction tail gas, and when a volume concentration of silane in the reaction tail gas is not higher than 5 vol%, stopping introduction of the gas containing silane to obtain the silicon-carbon composite material, where the silicon-carbon composite material includes a porous carbon matrix and a silicon-based material, where at least part of the silicon-based material is distributed in the pores of the porous carbon matrix, the silicon-carbon composite material satisfies Q2/Q1 ≤ 0.7, a button cell containing the silicon-carbon composite material is charged and discharged, a capacity corresponding to a voltage of 0.2 V to 0.4 V during charging is Q1, and a capacity corresponding to a voltage of 0.4 V to 0.6 V during charging is Q2.

In the preparation method of this disclosure, by monitoring that the volume concentration of silane in the tail gas is not higher than 5 vol%, the silicon-based material is made to deposit as little as possible on the surface of the porous carbon matrix, such that the silicon-carbon composite material satisfies Q2/Q1 ≤ 0.7, thereby effectively improving the cycling performance of the secondary battery.

In some embodiments, a total volume of silane introduced into the gas containing silane per kilogram of the porous carbon matrix is 400 L to 1500 L. In some embodiments, the total volume of silane introduced into the gas containing silane per kilogram of the porous carbon matrix is 650 L to 850 L.

In some embodiments, a temperature for depositing the silicon-based material is 450°C to 600°C; and/or a deposition time per kilogram of the porous carbon matrix is 1.2 h to 37.5 h; and/or a ventilation rate of the gas containing silane is 0.1 L/min to 10 L/min.

In some embodiments, at 510°C to 560°C, the deposition time per kilogram of the porous carbon matrix is 2.5 h to 20 h.

In some embodiments, depositing the silicon-based material in the pores of the porous carbon matrix includes an initial reaction stage, a middle reaction stage, and an end reaction stage, where based on an amount of silane introduced per kilogram of the porous carbon matrix, an amount of silane introduced in the initial reaction stage is 20 L to 170 L, an amount of silane introduced in the middle reaction stage is 390 L to 680 L, and an amount of silane introduced in the end reaction stage is 20 L to 170 L; and optionally, based on the amount of silane introduced per kilogram of the porous carbon matrix, the amount of silane introduced in the initial reaction stage is 150 L to 170 L, the amount of silane introduced in the middle reaction stage is 420 L to 490 L, and the amount of silane introduced in the end reaction stage is 150 L to 170 L.

Thus, in this disclosure, controlling the amount of silane deposited in different stages of the reaction process for depositing the silicon-based material in the pores of the porous carbon matrix helps the silane to enter the pores of the porous carbon matrix as much as possible, thereby depositing the silicon-based material in the pores of the porous carbon matrix rather than on the surface, and also helps to improve the utilization efficiency of silane.

In some embodiments, the method further includes:
forming a carbon coating on at least part of a surface of the silicon-carbon composite material; and
optionally, the forming a carbon coating on at least part of a surface of the silicon-carbon composite material includes:
   introducing a gas containing a carbon source into the reactor, and reacting at 550°C to 900°C for 0.5 h to 10 h, and optionally, reacting at 600°C to 700°C for 2 h to 6 h.

In this disclosure, a carbon coating is formed on the surface of the silane composite material to obtain a silicon-carbon composite material with reduced surface activity, reducing side reactions between it and the electrolyte. The prepared silicon-carbon composite material satisfies Q3/Q1 ≤ 0.37, which can effectively improve the initial coulombic efficiency of the secondary battery.

According to a third aspect, this disclosure provides a secondary battery, where the secondary battery includes a negative electrode sheet, and the negative electrode sheet includes the silicon-carbon composite material according to the first aspect of this disclosure, or the silicon-carbon composite material prepared by the preparation method of the silicon-carbon composite material according to the second aspect of this disclosure. The secondary battery has excellent cycling performance.

According to a fourth aspect, this disclosure provides an electric apparatus, where the electric apparatus includes the secondary battery according to the third aspect of this disclosure.

### BRIEF DESCRIPTION OF DRAWINGS

FIG. 1 is a schematic diagram of a battery cell according to an embodiment of this disclosure.
FIG. 2 is an exploded view of the battery cell shown in FIG. 1 according to an embodiment of this disclosure.
FIG. 3 is a schematic diagram of a battery module according to an embodiment of this disclosure.
FIG. 4 is a schematic diagram of a battery pack according to an embodiment of this disclosure.
FIG. 5 is an exploded view of the battery pack shown in FIG. 4 according to an embodiment of this disclosure.
FIG. 6 is a schematic diagram of an electric apparatus using a secondary battery as a power source according to an embodiment of this disclosure.

Description of reference numerals:
1. battery pack; 2. upper box body; 3. lower box body; 4. battery module; 5. battery cell; 51. housing; 52. electrode assembly; and 53. top cover assembly.

### DESCRIPTION OF EMBODIMENTS

Hereinafter, embodiments of a silicon-carbon composite material and preparation method thereof, a secondary battery, and an electric apparatus disclosed in this disclosure will be described in detail with appropriate reference to the accompanying drawings. However, there may be cases where unnecessary detailed descriptions are omitted. For example, there may be omissions of detailed descriptions of matters that are well-known to the public and repeated descriptions of actually identical structures. This is to avoid unnecessarily lengthening the following descriptions and to facilitate understanding by those skilled in the art. In addition, the accompanying drawings and the following descriptions are provided to enable those skilled in the art to fully understand this disclosure and are not intended to limit the subject matter described in the claims.

The "range" disclosed in this disclosure is defined in the form of a lower limit and an upper limit, and the given range is defined by selecting a lower limit and an upper limit, with the selected lower limit and upper limit defining the boundaries of a specific range. The range defined in this manner may include or exclude endpoints and may be arbitrarily combined, that is, any lower limit may be combined with any upper limit to form a range. For example, if ranges of 60-120 and 80-110 are listed for a specific parameter, it is also contemplated that ranges of 60-110 and 80-120 are understood. In addition, if the minimum range values listed are 1 and 2 and the maximum range values listed are 3, 4, and 5, the following ranges can all be contemplated: 1-3, 1-4, 1-5, 2-3, 2-4, and 2-5. In this disclosure, unless otherwise specified, the numerical range "a-b" represents an abbreviated representation of any real number combination between a and b, where a and b are both real numbers. For example, the numerical range "0-5" indicates that all real numbers between "0-5" have been fully listed in this text, and "0-5" is just an abbreviated representation of these numerical combinations. In addition, when a parameter is expressed as an integer equal to or greater than 2, it is equivalent to disclosing that the parameter is, for example, the integers 2, 3, 4, 5, 6, 7, 8, 9, 10, 11, or 12.

Unless otherwise specified, all embodiments and optional embodiments of this disclosure can be combined with each other to form a new technical solution.

Unless otherwise specified, all technical features and optional technical features of this disclosure can be combined with each other to form a new technical solution.

Unless otherwise specified, the terms used in this disclosure have the commonly understood meanings to those skilled in the art.

Unless otherwise specified, the values of various parameters mentioned in this disclosure can be measured by various commonly used test methods in the art, for example, can be measured according to the test methods given in this disclosure.

Silicon-based materials have higher theoretical specific capacity compared to carbon-based materials, but silicon-based materials exhibit significant expansion during charge-discharge cycles of batteries, leading to an unsatisfactory cycle life.

Currently, silicon-based materials can be deposited into the pores of a porous carbon matrix through chemical vapor infiltration to generate silicon-carbon composite materials, which can solve the cycle life problem to a certain extent. Silicon-carbon composite materials are typically used as negative electrode active materials for secondary batteries and have an important influence on the performance of secondary batteries. In current secondary batteries, the performance of silicon-carbon composite materials used as negative electrode active materials still cannot meet the demand for high cycling performance of secondary batteries.

Based on this, this disclosure provides a silicon-carbon composite material and preparation method thereof, a secondary battery, and an electric apparatus.

According to a first aspect, this disclosure provides a silicon-carbon composite material, where the silicon-carbon composite material includes:
a porous carbon matrix and a silicon-based material, where at least part of the silicon-based material is distributed in pores of the porous carbon matrix; and
the silicon-carbon composite material satisfies Q2/Q1 ≤ 0.7, a button cell containing the silicon-carbon composite material is charged and discharged, a capacity corresponding to a voltage of 0.2 V to 0.4 V during charging is Q1, and a capacity corresponding to a voltage of 0.4 V to 0.6 V during charging is Q2.

The silicon-carbon composite material of this disclosure satisfies Q2/Q1 ≤ 0.7, which reflects that most of the silicon-based material is deposited in the pores of the porous carbon matrix, with a small amount of silicon-based material deposited on the surface of the porous carbon matrix, effectively improving the cycling performance of the secondary battery.

The silicon-carbon composite material is prepared into a button half-cell and the button half-cell is charged and discharged. During charging process, the capacity is recorded as C1 when the button half-cell is charged to 0.2 V, the capacity is recorded as C2 when the button half-cell is charged to 0.4 V, the capacity is recorded as C3 when the button half-cell is charged to 0.6 V, and the capacity is recorded as C4 when the button half-cell is charged to 0.8 V. During charging process, the capacity from 0.2 V to 0.4 V is Q1 = (C2 - C1), the capacity from 0.4 V to 0.6 V is Q2 = (C3 - C2), and the capacity from 0.6 V to 0.8 V is Q3 = (C4 - C3). In the technical solution of this disclosure, the silicon-carbon composite material satisfies Q2/Q1 ≤ 0.7 to improve the cycling performance of the secondary battery. The above button half-cell is composed of a working electrode using the silicon-carbon composite material provided in this disclosure as the negative electrode active material and a counter electrode of metallic lithium.

It should be noted that the phase transformation of silicon in the silicon-carbon composite material during the lithium intercalation process is relatively complex, and the phase change during lithium intercalation can be generally summarized as Si → LiₓSi → Li₁₅Si₄, while the delithiation process is the reverse, and the phase change during delithiation can be generally summarized as Li₁₅Si₄ → LiₓSi → Si, where x is a value between 0 and 15.

During charging process of the button half-cell, Q1 corresponds to the charging capacity from 0.2 V to 0.4 V, which originates from the phase change Li₁₅Si₄ → LiₓSi of silicon in the internal pores of the porous carbon matrix; Q2 corresponds to the charging capacity from 0.4 V to 0.6 V, which originates from the phase change Li₁₅Si₄ → LiₓSi → Si of silicon on the surface of the porous carbon matrix, as well as the phase change LiₓSi → Si of silicon inside the porous carbon matrix; and Q3 corresponds to the charging capacity from 0.6 V to 0.8 V, which originates from the delithiation phase change of oxygen defects and the delithiation phase change of LiSiₓC_{y}. The corresponding values represent the capacity contributed by each phase change, with larger values indicating higher contributed capacity and correspondingly higher percentage of that phase.

Among these phase changes, the main factor deteriorating the cycling performance of the silicon-carbon composite material is the silicon on the surface of the porous carbon matrix in Q2, so during the deposition of silicon, the silicon-based material should be deposited as much as possible in the pores of the porous carbon matrix, reducing the enrichment of the silicon-based material on the surface of the porous carbon matrix, which can reduce Q2/Q1 of the silicon-carbon composite material and prolong its cycle life.

The silicon-carbon composite material provided in this disclosure includes a porous carbon matrix and a silicon-based material distributed in the pores of the porous carbon matrix. The porous carbon matrix can improve the conductivity of the silicon-based material and can also serve as a buffer medium for the volume expansion of the silicon-based material during charge-discharge processes, effectively alleviating the problem of secondary battery volume increase caused by the expansion of the silicon-based material. Further, the silicon-carbon composite material satisfying Q2/Q1 ≤ 0.7 can effectively improve the cycling performance of the secondary battery.

In some embodiments, the silicon-carbon composite material satisfies 0.3 ≤ Q2/Q1 ≤ 0.7. In further embodiments, the silicon-carbon composite material satisfies 0.5 ≤ Q2/Q1 ≤ 0.65.

The silicon-carbon composite material satisfying the corresponding range of Q2/Q1 is more conducive to improving the cycling performance of the secondary battery. For example, Q2/Q1 can be values such as 0.51, 0.52, 0.53, 0.54, 0.55, 0.56, 0.57, 0.58, 0.59, 0.60, 0.61, 0.62, 0.63, and 0.64.

In some embodiments, at least part of the surface of the silicon-carbon composite material has a coating. Optionally, a thickness of the coating is 2 nm to 100 nm. This disclosure has no particular limitation on the thickness of the coating, which can be adjusted according to actual needs. For example, the coating thickness can be 5 nm to 90 nm, 10 nm to 80 nm, 20 nm to 80 nm, 20 nm to 60 nm, or the like, specifically such as 10 nm, 20 nm, 30 nm, 40 nm, or 50 nm.

It should be noted that the Q3 capacity originates from the delithiation phase change of oxygen defects and the delithiation phase change of LiSiₓC_{y}. Usually, after deposition to form the silicon-carbon composite material, the activity of the silicon-based material is very high, and by forming a coating on the surface of the silicon-carbon composite material, the reaction activity of the material surface can be reduced, thereby reducing Q3/Q1 of the silicon-carbon composite material and further improving the initial coulombic efficiency of the secondary battery.

It should be noted that the coating can be a continuous and complete coating or an incomplete coating. "The continuous and complete coating" indicates the entire surface of the silicon-carbon composite material being covered by the coating. "The incomplete coating" indicates at least part of the surface of the silicon-carbon composite material being covered by the coating.

According to specific embodiments, the coating is a carbon coating.

In some embodiments, the silicon-carbon composite material having a carbon coating has a powder resistivity of less than 50 Ω·cm at 4 MPa. The silicon-carbon composite material has excellent conductivity, which in turn helps to improve the kinetic performance of the secondary battery.

In some embodiments, the silicon-carbon composite material satisfies Q3/Q1 ≤ 0.37, where a capacity corresponding to a voltage of 0.6 V to 0.8 V during charging is Q3.

The silicon-carbon composite material satisfying Q3/Q1 ≤ 0.37 can effectively improve the initial coulombic efficiency of the secondary battery.

In some embodiments, the Q3/Q1 of the silicon-carbon composite material can be greater than 0.37, for example, 0.38, 0.40, 0.42, or 0.44.

In some embodiments, the silicon-carbon composite material satisfies 0.25 ≤ Q3/Q1 ≤ 0.37. Optionally, the silicon-carbon composite material satisfies 0.3 ≤ Q3/Q1 ≤ 0.37.

The silicon-carbon composite material satisfying the corresponding range of Q3/Q1 is more conducive to improving the initial coulombic efficiency of the secondary battery. For example, Q3/Q1 can be values such as 0.25, 0.28, 0.30, 0.31, 0.32, 0.33, 0.34, 0.35, 0.36, and 0.37, but is not limited thereto.

In some embodiments, the porous carbon matrix includes micropores and mesopores. Optionally, a pore volume ratio of the micropores to the mesopores is 1 to 40, and optionally, 3 to 10.

The porous carbon matrix includes pores of different pore sizes. For example, the porous carbon includes micropores, where micropores refer to pores with a pore size less than 2 nm (usually 0.5 nm to 2 nm). As another example, the porous carbon includes mesopores, where mesopores refer to pores with a pore size in the range of 2 nm to 50 nm. When the pore volume ratio of micropores to mesopores in the porous carbon matrix is within the above range, it can provide suitable space for the deposition of the silicon-based material, thereby making the silicon-carbon material have a suitable capacity.

Exemplarily, the pore volumes of micropores and mesopores in the porous carbon matrix can be tested using known methods in the art. For example, the test may be performed in accordance with GB/T 19587-2017 via an analysis and test method for nitrogen adsorption specific surface area, with the calculation performed using the BET method. The analysis and test for nitrogen adsorption specific surface area can be conducted using, for example, the TriStar 3020 specific surface area and porosity analyzer from Micromeritics, USA.

In some embodiments, the silicon-carbon composite material satisfies at least one of the following:
a specific surface area BET of the silicon-carbon composite material is 0.1 m²/g to 5 m²/g, and is optionally 1 m²/g to 3 m²/g;
a percentage of the silicon-based material in the silicon-carbon composite material is 30% to 60%, and is optionally 40% to 50%; and
at least part of the silicon-based material in the silicon-carbon composite material exists in a form of amorphous silicon.

Exemplarily, the specific surface area of the silicon-carbon composite material has the commonly understood meaning in the art and can be tested using known methods in the art. For example, the test may be performed in accordance with GB/T 19587-2017 via an analysis and test method for nitrogen adsorption specific surface area, with the calculation performed using the BET method. The analysis and test for nitrogen adsorption specific surface area can be conducted using, for example, the TriStar 3020 specific surface area and porosity analyzer from Micromeritics, USA.

Exemplarily, the percentage of the silicon-based material in the silicon-carbon composite material can be tested using inductively coupled plasma atomic emission spectroscopy (Inductively Coupled Plasma Atomic Emission Spectroscopy, ICP-AES).

According to a second aspect, this disclosure provides a preparation method of the above silicon-carbon composite material, where the method includes the following steps:
introducing a gas containing silane into a reactor including a porous carbon matrix to deposit a silicon-based material in pores of the porous carbon matrix; and
monitoring the reaction tail gas, and when a volume concentration of silane in the reaction tail gas is not higher than 5 vol%, stopping the introduction of the gas containing silane to obtain the silicon-carbon composite material.

In this disclosure, during the process of depositing the silicon-based material in the pores of the porous carbon matrix, when the volume concentration of silane in the reaction tail gas is monitored to be not higher than 5 vol%, introduction of the gas containing silane is controlled to stop, to obtain the silicon-carbon composite material, thereby controlling the amount of silicon-based material deposited on the surface of the porous carbon matrix. Thus, the prepared silicon-carbon composite material satisfies Q2/Q1 ≤ 0.7, such that most of the silicon-based material is deposited in the pores of the porous carbon matrix, with as little silicon-based material as possible enriched on the surface of the porous carbon matrix, which can effectively improve the cycling performance of the secondary battery.

The volume concentration of silane in the reaction tail gas can be monitored using any conventional method or using commercially available silane detection instruments. It should be understood that under normal process conditions, there is a trace amount of unreacted silane gas discharged from the tail gas (for example, when the volume concentration is less than 0.01 vol%), at which time the reaction is still proceeding, and it is not necessary to stop the introduction of the gas containing silane.

In some embodiments, a total volume of the silane introduced into the gas containing silane per kilogram of the porous carbon matrix is 400 L to 1500 L. Optionally, the total volume of the silane introduced into the gas containing silane per kilogram of the porous carbon matrix is 650 L to 850 L. Exemplarily, the total volume of the silane introduced into the gas containing silane per kilogram of the porous carbon matrix is 650 L, 680 L, 700 L, 720 L, 750 L, 780 L, 800 L, 820 L, 840 L, or the like. The total volume of the silane in the gas containing silane can be determined according to the amount of silicon to be deposited, and this disclosure has no particular limitation thereon.

In the technical solution of this disclosure, during the process of depositing the silicon-based material in the pores of the porous carbon matrix, the total amount of silane introduced is an important process parameter. For every kilogram of porous carbon matrix, the total amount of silane introduced depends on the gas flow rate range of the gas containing silane introduced and the reaction duration. Thus, in this disclosure, limiting the total amount of silane introduced is more conducive to making the prepared silicon-carbon composite material satisfy Q2/Q1 ≤ 0.7, thereby effectively improving the cycling performance of the secondary battery.

The gas containing silane described herein, in addition to silane, also includes a carrier gas. The carrier gas is usually an inert gas, such as nitrogen.

In some embodiments, the volume concentration range of silane in the gas containing silane is greater than 5 vol% to 100 vol%, and is optionally 20 vol% to 80 vol%. Exemplarily, the volume concentration of silane in the gas containing silane is 20 vol%, 30 vol%, 40 vol%, 50 vol%, 60 vol%, 70 vol%, or 80 vol%.

According to specific embodiments, the silane is monosilane.

This disclosure has no special limitation on the volume concentration range of silane in the gas containing silane, and any conventional volume concentration range of silane can be used.

In some embodiments, a temperature for depositing the silicon-based material is 450°C to 600°C; and/or a deposition time per kilogram of the porous carbon matrix is 1.2 h to 37.5 h; and/or a ventilation rate of the gas containing silane is 0.1 L/min to 10 L/min. Optionally, at 510°C to 560°C, the deposition time per kilogram of the porous carbon matrix is 2.5 h to 20 h.

This disclosure has no special limitation on the gas flow rate range of silane in the gas containing silane, and any conventional gas flow rate range of silane can be used. Exemplarily, the ventilation rate of the gas containing silane is in the range of 0.8 L/min to 8 L/min, 1 L/min to 6 L/min, 2 L/min to 8 L/min, or 3 L/min to 6 L/min. More specifically, the ventilation rate of the gas containing silane is 0.8 L/min, 1 L/min, 2 L/min, 3 L/min, 3.5 L/min, 4 L/min, 4.5 L/min, 5 L/min, 6 L/min, 8 L/min, or the like.

Exemplarily, the temperature range for depositing the silicon-based material is 500°C to 560°C, 510°C to 550°C, 520°C to 550°C, or 520°C to 540°C. More specifically, the temperature for depositing the silicon-based material is 480°C, 490°C, 500°C, 510°C, 515°C, 520°C, 525°C, 530°C, 535°C, 540°C, 550°C, 560°C, 570°C, or the like.

Under the conditions of different determined reaction temperatures, ventilation rates, and proportions of silane in the gas containing silane, according to the method of this disclosure, by monitoring the percentage of silane in the tail gas, the reaction can be ended in a timely manner, avoiding excessive silicon deposition on the surface of the carbon matrix, thereby reducing the value of Q2/Q1.

In the technical solution of this disclosure, during the process of depositing the silicon-based material in the pores of the porous carbon matrix, the deposition temperature and reaction duration are important process parameters. Usually, a higher deposition temperature indicates a shorter reaction duration. Certainly, the determination of the reaction endpoint still depends on when the volume concentration of silane in the reaction tail gas can be monitored to be not higher than 5 vol%.

In some embodiments, depositing the silicon-based material in the pores of the porous carbon matrix includes an initial reaction stage, a middle reaction stage, and an end reaction stage, where based on an amount of silane introduced per kilogram of the porous carbon matrix, an amount of silane introduced in the initial reaction stage is 20 L to 170 L, an amount of silane introduced in the middle reaction stage is 390 L to 680 L, and an amount of silane introduced in the end reaction stage is 20 L to 170 L. In some specific embodiments, based on the amount of silane introduced per kilogram of the porous carbon matrix, the amount of silane introduced in the initial reaction stage is 150 L to 170 L, the amount of silane introduced in the middle reaction stage is 420 L to 490 L, and the amount of silane introduced in the end reaction stage is 150 L to 170 L.

The reaction process of depositing the silicon-based material in the pores of the porous carbon matrix is divided into an initial reaction stage, a middle reaction stage, and an end reaction stage. In the initial reaction stage, a silicon-carbon interface is formed between the silicon-based material and the inner surfaces and outer surfaces of the porous carbon matrix, and the reaction rate is relatively slow. At this time, if the amount of silane introduced in the early stage of the reaction is relatively large, the utilization rate of silane is relatively low. In the end reaction stage, the reaction of depositing the silicon-based material in the pores of the porous carbon matrix gradually reaches saturation. At this time, if the amount of silane introduced in the end reaction stage is relatively large, the silane is more likely to deposit on the surface of the porous carbon matrix rather than in the pores of the porous carbon matrix. Therefore, the amount of silane introduced in the initial reaction stage and the end reaction stage is less than the amount of silane introduced in the middle reaction stage.

Thus, in this disclosure, dividing the reaction process of depositing the silicon-based material in the pores of the porous carbon matrix helps to improve the utilization efficiency of silane.

In some specific embodiments, the deposition amounts in the initial reaction stage, middle reaction stage, and end reaction stage of depositing the silicon-based material in the pores of the porous carbon matrix can be controlled by controlling the deposition time, concentration of silane, flow rate, and the like to control the amount of silane introduced in each stage. For example, based on the total duration of depositing the silicon-based material, the duration of the initial reaction stage accounts for 10% to 20%, the duration of the middle reaction stage accounts for 60% to 80%, and the duration of the end reaction stage accounts for 10% to 20%. The volume concentration of silane in the initial reaction stage and the end reaction stage can be controlled to be less than the volume concentration of silane in the middle reaction stage, and/or the gas flow rate of the gas containing silane in the initial reaction stage and the end reaction stage is less than the gas flow rate of the gas containing silane in the middle reaction stage.

In some embodiments, during the process of depositing the silicon-based material in the pores of the porous carbon matrix, the pressure range in the reactor is greater than 0 kPa to 1 kPa, and is optionally 100 Pa to 500 Pa.

This disclosure has no special limitation on the reaction pressure, and the pressure during the deposition process can be a slight positive pressure.

In some embodiments, the method further includes:
forming a carbon coating on at least part of a surface of the silicon-carbon composite material; and
optionally, the forming a carbon coating on at least part of a surface of the silicon-carbon composite material includes:
   introducing a gas containing a carbon source into the reactor, and reacting at 550°C to 900°C for 0.5 h to 10 h, and optionally, reacting at 600°C to 700°C for 2 h to 6 h.

In specific embodiments, after the introduction of the gas containing silane is stopped, there is no need to replace the reactor, and a gas containing a carbon source is immediately introduced into the reactor for surface coating.

Thus, in this disclosure, a carbon coating is formed on the surface of the silane composite material to obtain the silicon-carbon composite material. At this time, the prepared silicon-carbon composite material satisfies Q3/Q1 ≤ 0.37, which can effectively improve the initial coulombic efficiency of the secondary battery.

In some embodiments, the carbon source is selected from at least one of the following: methane, ethylene, acetylene, and propane.

This disclosure has no special limitation on the selection of the carbon source, and any conventional carbon source can be used.

In some embodiments, the volume concentration range of the carbon source in the gas containing the carbon source is greater than 0 vol% to 100 vol%; the volume concentration range of the carbon source is optionally 20 vol% to 80 vol%.

This disclosure has no special limitation on the volume concentration range of the carbon source in the gas containing the carbon source, and any conventional volume concentration range of the carbon source can be used.

In some embodiments, the gas flow rate range of the carbon source in the gas containing the carbon source is greater than 0.1 L/min to 10 L/min; the gas flow rate range of the carbon source is optionally greater than 0.1 L/min to 4 L/min.

This disclosure has no special limitation on the gas flow rate range of the carbon source in the gas containing the carbon source, and any conventional gas flow rate range of the carbon source can be used.

According to a third aspect, this disclosure provides a secondary battery, where the secondary battery includes a negative electrode sheet, and the negative electrode sheet includes the silicon-carbon composite material according to the first aspect of this disclosure, or the silicon-carbon composite material prepared by the preparation method of a silicon-carbon composite material according to the second aspect of this disclosure. The secondary battery has excellent cycling performance.

In addition, the secondary battery and electric apparatus of this disclosure will be described below with appropriate reference to the accompanying drawings.

In one embodiment of this disclosure, a secondary battery is provided.

The term "secondary battery" mentioned herein refers to a battery cell, a battery module, or a battery pack. The following descriptions are provided separately.

Typically, a secondary battery cell includes a positive electrode sheet, a negative electrode sheet, an electrolyte, and a separator. During the charge-discharge process of the battery, active ions intercalate and deintercalate between the positive electrode sheet and the negative electrode sheet. The electrolyte conducts ions between the positive electrode sheet and the negative electrode sheet. The separator is provided between the positive electrode sheet and the negative electrode sheet, mainly to prevent short circuits between the positive and negative electrodes, while allowing ions to pass through.

### Negative electrode sheet

The negative electrode sheet includes a negative electrode current collector and a negative electrode film layer provided on at least one surface of the negative electrode current collector, the negative electrode film layer includes a negative electrode active material, and the negative electrode active material may include the silicon-carbon composite material according to the first aspect of this disclosure.

As an example, the negative electrode current collector has two opposite surfaces in its own thickness direction, and the negative electrode film layer is provided on either or both of the two opposite surfaces of the negative electrode current collector.

In some embodiments, the negative electrode current collector may adopt a metal foil or a composite current collector. For example, as the metal foil, copper foil can be used. The composite current collector may include a polymer material substrate and a metal layer formed on at least one surface of the polymer material substrate. The composite current collector can be formed by forming a metal material (copper, copper alloy, nickel, nickel alloy, titanium, titanium alloy, silver, silver alloy, or the like) on a polymer material substrate (such as a substrate of polypropylene (PP), polyethylene terephthalate (PET), polybutylene terephthalate (PBT), polystyrene (PS), or polyethylene (PE)).

In some embodiments, the negative electrode active material may further adopt negative electrode active materials known in the art for batteries. As an example, the negative electrode active material may further include at least one of the following materials: artificial graphite, natural graphite, soft carbon, hard carbon, silicon-based materials, tin-based materials, lithium titanate, and the like. The silicon-based material may be selected from at least one of elemental silicon, silicon oxide compounds, silicon-carbon composites, silicon-nitrogen composites, and silicon alloys. The tin-based material may be selected from at least one of elemental tin, tin oxide compounds, and tin alloys.

In some embodiments, the negative electrode film layer may further optionally include a binder. The binder may be selected from at least one of styrene-butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA), and carboxymethyl chitosan (CMCS).

In some embodiments, the negative electrode film layer may further optionally include a conductive agent. The conductive agent may be selected from at least one of superconducting carbon, acetylene black, carbon black, Ketjen black, carbon dots, carbon nanotubes, graphene, and carbon nanofibers.

In some embodiments, the negative electrode film layer may further optionally include other auxiliaries, such as thickeners (for example, carboxymethyl cellulose sodium (CMC-Na)).

In some embodiments, the negative electrode sheet can be prepared in the following manner: dispersing the above components for preparing the negative electrode sheet, such as the negative electrode active material, conductive agent, binder, and any other components, in a solvent (for example, deionized water) to form a negative electrode slurry, applying the negative electrode slurry to the negative electrode current collector, and performing drying and cold pressing to obtain the negative electrode sheet.

### Positive electrode sheet

The positive electrode sheet includes a positive electrode current collector and a positive electrode film layer provided on at least one surface of the positive electrode current collector, the positive electrode film layer including a positive electrode active material.

As an example, the positive electrode current collector has two opposite surfaces in its own thickness direction, and the positive electrode film layer is provided on either or both of the two opposite surfaces of the positive electrode current collector.

In some embodiments, the positive electrode current collector may adopt a metal foil or a composite current collector. For example, as the metal foil, aluminum foil can be used. The composite current collector may include a polymer material substrate and a metal layer formed on at least one surface of the polymer material substrate. The composite current collector can be formed by forming a metal material (aluminum, aluminum alloy, nickel, nickel alloy, titanium, titanium alloy, silver, silver alloy, or the like) on a polymer material substrate (such as a substrate of polypropylene (PP), polyethylene terephthalate (PET), polybutylene terephthalate (PBT), polystyrene (PS), or polyethylene (PE)).

In some embodiments, when the battery cell is a lithium-ion battery, the positive electrode active material may adopt positive electrode active materials known in the art for lithium-ion batteries. As an example, the positive electrode active material may include at least one of the following materials: lithium-containing phosphates with olivine structure, lithium transition metal oxides, and their respective modified compounds. However, this disclosure is not limited to these materials, and other conventional materials that can be used as positive electrode active materials for batteries can also be used. These positive electrode active materials can be used alone or in combination of two or more. Examples of lithium transition metal oxides may include but are not limited to at least one of lithium cobalt oxide (for example, LiCoO₂), lithium nickel oxide (for example, LiNiO₂), lithium manganese oxide (for example, LiMnO₂ or LiMn₂O₄), lithium nickel cobalt oxide, lithium manganese cobalt oxide, lithium nickel manganese oxide, lithium nickel cobalt manganese oxide (for example, LiNi_{1/3}Co_{1/3}Mn_{1/3}O₂ (also abbreviated as NCM333), LiNi_{0.5}Co_{0.2}Mn_{0.3}O₂ (also abbreviated as NCM523), LiNi_{0.5}Co_{0.25}Mn_{0.25}O₂ (also abbreviated as NCM211), LiNi_{0.6}Co_{0.2}Mn_{0.2}O₂ (also abbreviated as NCM622), LiNi_{0.8}Co_{0.1}Mn_{0.1}O₂ (also abbreviated as NCM811)), lithium nickel cobalt aluminum oxide (for example, LiNi_{0.85}Co_{0.1}Al_{0.05}O₂) and their modified compounds. Examples of lithium-containing phosphates with olivine structure may include but are not limited to at least one of lithium iron phosphate (for example, LiFePO₄ (also abbreviated as LFP)), lithium iron phosphate and carbon composite materials, lithium manganese phosphate (for example, LiMnPO₄), lithium manganese phosphate and carbon composite materials, lithium manganese iron phosphate, lithium manganese iron phosphate and carbon composite materials.

During the charge-discharge process of the battery, Li deintercalation and consumption occur, and the molar content of Li differs when the battery is discharged to different states. In the enumeration of positive electrode active materials in this disclosure, the molar content of Li is in the initial state of the material, that is, the state before feeding, and when the positive electrode active material is applied to the battery system, after charge-discharge cycles, the molar content of Li changes.

In the enumeration of positive electrode active materials in this disclosure, the molar content of O is only a theoretical state value, lattice oxygen release causes changes in the molar content of oxygen, and the actual molar content of O fluctuates.

In some embodiments, when the battery cell is a sodium-ion battery, the positive electrode active material may adopt positive electrode active materials known in the art for sodium-ion batteries. As an example, the positive electrode active material may include sodium transition metal oxides, polyanionic compounds (phosphates, fluorophosphates, pyrophosphates, and sulfates), Prussian blue-like compounds, and the like. However, this disclosure is not limited to these materials, and other conventional materials that can be used as positive electrode active materials for batteries can also be used.

As an optional technical solution of this disclosure, in the sodium transition metal oxides, the transition metal can be at least one of Mn, Fe, Ni, Co, Cr, Cu, Ti, Zn, V, Zr, and Ce. The sodium transition metal oxide is, for example, NaₓMO₂, where M is one or more of Ti, V, Mn, Co, Ni, Fe, Cr, and Cu, and 0 < x ≤ 1, such as sodium iron composite oxide (NaFeO₂), sodium cobalt composite oxide (NaCoO₂), sodium chromium composite oxide (NaCrO₂), sodium manganese composite oxide (NaMnO₂), sodium nickel composite oxide (NaNiO₂), sodium nickel titanium composite oxide (NaNi_{1/2}Ti_{1/2}O₂), sodium nickel manganese composite oxide (NaNi_{1/2}Mn_{1/2}O₂), sodium iron manganese composite oxide (Na_{2/3}Fe_{1/3}Mn_{2/3}O₂), or sodium nickel cobalt manganese composite oxide (NaNi_{1/3}Co_{1/3}Mn_{1/3}O₂).

As an optional technical solution of this disclosure, the polyanionic compound can be a class of compounds having sodium ions, transition metal ions, and tetrahedral (YO₄)ⁿ⁻ anionic units. The transition metal can be at least one of Mn, Fe, Ni, Co, Cr, Cu, Ti, Zn, V, Zr, and Ce; Y can be at least one of P, S, and Si; and n represents the valence of (YO₄)ⁿ⁻.

The polyanionic compound can also be a class of compounds having sodium ions, transition metal ions, tetrahedral (YO₄)ⁿ⁻ anionic units, and halogen anions. The transition metal can be at least one of Mn, Fe, Ni, Co, Cr, Cu, Ti, Zn, V, Zr, and Ce, Y can be at least one of P, S, and Si, n represents the valence of (YO₄)ⁿ⁻, and the halogen can be at least one of F, Cl, and Br.

The polyanionic compound can also be a class of compounds having sodium ions, tetrahedral (YO₄)ⁿ⁻ anionic units, polyhedral units (ZO_{y})^{m+}, and optional halogen anions. Y can be at least one of P, S, and Si, n represents the valence of (YO₄)ⁿ⁻, Z represents a transition metal and can be at least one of Mn, Fe, Ni, Co, Cr, Cu, Ti, Zn, V, Zr, and Ce, m represents the valence of (ZO_{y})^{m+}, and the halogen can be at least one of F, Cl, and Br.

The polyanionic compound is, for example, at least one of NaFePO₄, Na₃V₂(PO₄)₃, NaM'PO₄F (where M' is one or more of V, Fe, Mn, and Ni), and Na₃(VO_{y})₂(PO₄)₂F_{3-2y} (0 ≤ y ≤ 1).

The Prussian blue-like compound can be a class of compounds having sodium ions, transition metal ions, and cyano ions (CN-). The transition metal can be at least one of Mn, Fe, Ni, Co, Cr, Cu, Ti, Zn, V, Zr, and Ce. The Prussian blue-like compound is, for example, NaₐMe_{b}Me'_{c}(CN)₆, where Me and Me' are each independently at least one of Ni, Cu, Fe, Mn, Co, and Zn, 0 < a ≤ 2, 0 < b < 1, and 0 < c < 1.

In some embodiments, the positive electrode film layer may further optionally include a binder. As an example, the binder may include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, and fluorinated acrylate resin.

In some embodiments, the positive electrode film layer may further optionally include a conductive agent. As an example, the conductive agent may include at least one of superconducting carbon, acetylene black, carbon black, Ketjen black, carbon dots, carbon nanotubes, graphene, and carbon nanofibers.

In some embodiments, the positive electrode sheet can be prepared in the following manner: dispersing the above components for preparing the positive electrode sheet, such as the positive electrode active material, conductive agent, binder, and any other components, in a solvent (for example, N-methylpyrrolidone) to form a positive electrode slurry, applying the positive electrode slurry to the positive electrode current collector, and performing drying and cold pressing to obtain the positive electrode sheet.

### Electrolyte

The electrolyte conducts ions between the positive electrode sheet and the negative electrode sheet. This disclosure has no specific limitation on the type of electrolyte, which can be selected according to needs. For example, the electrolyte can be liquid, gel-state, or all-solid-state.

In some embodiments, the electrolyte adopts a liquid electrolyte. The liquid electrolyte includes an electrolytic salt and a solvent.

In some embodiments, the electrolytic salt may be selected from at least one of lithium hexafluorophosphate, lithium tetrafluoroborate, lithium perchlorate, lithium hexafluoroarsenate, lithium bis(fluorosulfonyl)imide, lithium bis(trifluoromethanesulfonyl)imide, lithium trifluoromethanesulfonate, lithium difluorophosphate, lithium difluoro(oxalato)borate, lithium bis(oxalato)borate, lithium difluoro(dioxalato)phosphate, and lithium tetrafluoro(oxalato)phosphate.

In some embodiments, the solvent may be selected from at least one of ethylene carbonate, propylene carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, dimethyl sulfone, methyl ethyl sulfone, and diethyl sulfone.

In some embodiments, the electrolyte may further optionally include additives. For example, the additives may include negative electrode film-forming additives and positive electrode film-forming additives, and may also include additives that can improve certain performances of the battery, such as additives that improve battery overcharge performance, additives that improve battery high-temperature or low-temperature performance, or the like.

### Separator

In some embodiments, the battery cell further includes a separator. This disclosure has no particular limitation on the type of separator, and any known porous structure separator with good chemical stability and mechanical stability can be selected.

In some embodiments, the material of the separator may be selected from at least one of glass fiber, non-woven fabric, polyethylene, polypropylene, and polyvinylidene fluoride. The separator can be a single-layer film or a multi-layer composite film, with no particular limitation. When the separator is a multi-layer composite film, the materials of each layer can be the same or different, with no particular limitation.

In some embodiments, the positive electrode sheet, the negative electrode sheet, and the separator can be made into an electrode assembly through a winding process or a lamination process.

In some embodiments, the battery cell may include an outer package. The outer package can be used to encapsulate the above electrode assembly and electrolyte.

In some embodiments, the outer package of the battery cell can be a hard shell, such as a hard plastic shell, an aluminum shell, or a steel shell. The outer package of the battery cell can also be a soft package, such as a pouch-type soft package. The material of the soft package can be plastic, and examples of the plastic include polypropylene, polybutylene terephthalate, and polybutylene succinate.

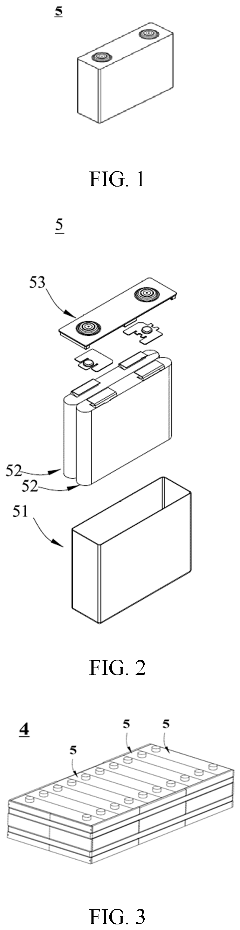

This disclosure has no particular limitation on the shape of the battery cell, which can be cylindrical, prismatic, or any other shape. For example, FIG. 1 shows a prismatic structure battery cell 5 as an example.

In some embodiments, referring to FIG. 2, the outer package may include a housing 51 and a top cover assembly 53. The housing 51 may include a bottom plate and side plates connected to the bottom plate, and the bottom plate and side plates enclose to form an accommodating cavity. The housing 51 has an opening communicating with the accommodating cavity, and the top cover assembly 53 can cover the opening to close the accommodating cavity. The positive electrode sheet, the negative electrode sheet, and the separator can form an electrode assembly 52 through a winding process or a lamination process. The electrode assembly 52 is encapsulated in the accommodating cavity. The electrolyte is infiltrated into the electrode assembly 52. The number of electrode assemblies 52 contained in the battery cell 5 can be one or more, and those skilled in the art can select according to specific actual needs.

In some embodiments, battery cells can be assembled into a battery module, the number of battery cells contained in the battery module can be one or more, and the specific number can be selected by those skilled in the art according to the application and capacity of the battery module.

FIG. 3 shows a battery module 4 as an example. Referring to FIG. 3, in the battery module 4, multiple battery cells 5 can be arranged in sequence along the length direction of the battery module 4. Certainly, they can also be arranged in any other manner. Further, the multiple battery cells 5 can be fixed by fasteners.

Optionally, the battery module 4 may further include an outer shell with an accommodating space, and the multiple battery cells 5 are accommodated in the accommodating space.

In some embodiments, the above battery module can also be assembled into a battery pack, the number of battery modules contained in the battery pack can be one or more, and the specific number can be selected by those skilled in the art according to the application and capacity of the battery pack.

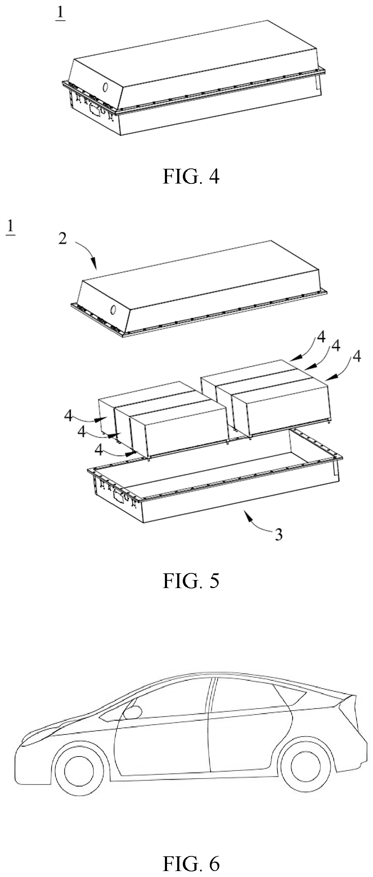

FIG. 4 and FIG. 5 show a battery pack 1 as an example. Referring to FIG. 4 and FIG. 5, the battery pack 1 may include a battery box and multiple battery modules 4 provided in the battery box. The battery box includes an upper box body 2 and a lower box body 3, and the upper box body 2 can cover the lower box body 3 and form a closed space for accommodating the battery modules 4. The multiple battery modules 4 can be arranged in the battery box in any manner.

According to a fourth aspect, this disclosure provides an electric apparatus, the electric apparatus including the secondary battery according to the third aspect of this disclosure.

The secondary battery can be used as a power source of the electric apparatus or as an energy storage unit of the electric apparatus. The electric apparatus can include mobile devices (for example, mobile phones or notebook computers), electric vehicles (for example, pure electric vehicles, hybrid electric vehicles, plug-in hybrid electric vehicles, electric bicycles, electric scooters, electric golf carts, or electric trucks), electric trains, ships, satellites, energy storage systems, or the like, but is not limited thereto.

For the electric apparatus, a battery cell, battery module, or battery pack can be selected according to its usage needs.

FIG. 6 shows an electric apparatus as an example. The electric apparatus is a pure electric vehicle, a hybrid electric vehicle, plug-in hybrid electric vehicle, or the like. To meet the high power and high energy density requirements of the electric apparatus for the secondary battery, a battery pack or battery module can be used.

In another example, the apparatus can be a mobile phone, a tablet computer, a notebook computer, or the like. Such apparatus usually requires lightweight and thin design, and a battery cell can be used as the power source.

### Examples

Hereinafter, examples of this disclosure are described. The examples described below are exemplary and are only used to explain this disclosure, and should not be understood as limiting this disclosure. For specific techniques or conditions not noted in the examples, they are carried out according to the techniques or conditions described in the literature in the art or according to the product instructions. Reagents or instruments used without noted manufacturers are all conventional products that can be obtained commercially.

### Preparation of silicon-carbon composite material

### Example 1

Step a. 1 kg of porous hard carbon matrix (with a pore volume ratio of micropores to mesopores being 6.5) was placed in a rotary kiln, heated to 500°C under nitrogen protection, and held for 2 h so that the air adsorbed in the porous carbon matrix was fully desorbed.

Step b. The rotary kiln was evacuated to a vacuum degree of 1×10⁻⁵ Pa, the pressure was held for 5 min, and then nitrogen was introduced until the pressure in the kiln was returned to normal.

Step c. Step b was repeated until the oxygen content in the tail gas was reduced below 200 ppm.

Step d. A mixed gas of monosilane and nitrogen was introduced, with a ratio of the mixed gas of monosilane and nitrogen being 1:4 and a ventilation rate being 4 L/min, a slight positive pressure of 200 Pa was maintained in the kiln, and the rotary kiln rotation frequency was 40 Hz.

Step e. The concentration of monosilane in the reaction tail gas was monitored using a chromatograph (model: Agilent Lab GC 8860), and the introduction of the mixed gas of monosilane and nitrogen was stopped when the concentration of monosilane in the reaction tail gas reached 4.8 vol%, with a total introduction amount of monosilane being 780 L.

Step f. The temperature in the rotary kiln was raised to 600°C, and a mixed gas of acetylene and nitrogen was introduced for 5 hours, with a ratio of the mixed gas of acetylene and nitrogen being 1:4 and a ventilation rate being 2 L/min. A slight positive pressure of 200 Pa was maintained in the kiln, and the rotary kiln rotation frequency was kept at 40 Hz, whereby a silicon-carbon composite material with a carbon coating of about 10 nm thickness was obtained, with the total introduction amount of acetylene being 600 L.

### Example 2

The silicon-carbon composite material of Example 2 was prepared in a similar manner to that of Example 1, except that the total introduction amount of monosilane was 720 L and, when the introduction of the mixed gas of monosilane and nitrogen was stopped, the concentration of monosilane in the reaction tail gas was 2.5 vol%.

### Example 3

The silicon-carbon composite material of Example 3 was prepared in a similar manner to that of Example 1, except that the ventilation rate of the mixed gas of monosilane and nitrogen was 3.8 L/min and, when the introduction of the mixed gas of monosilane and nitrogen was stopped, the concentration of monosilane in the reaction tail gas was 3.7 vol%.

### Example 4

The silicon-carbon composite material of Example 4 was prepared in a similar manner to that of Example 1, except that no carbon coating was formed on the surface of the silicon-carbon composite material and, when the introduction of the mixed gas of monosilane and nitrogen was stopped, the concentration of monosilane in the reaction tail gas was 4.7 vol%.

### Comparative Example 1

The silicon-carbon composite material of Comparative Example 1 was prepared in a similar manner to that of Example 1, except that when the introduction of the mixed gas of monosilane and nitrogen was stopped, the concentration of monosilane in the reaction tail gas was 5.5 vol%.

### Preparation of button cell

The negative electrode sheet was prepared as follows: the above-prepared silicon-carbon composite material, conductive agent carbon black, and binder polyacrylic acid were mixed in a mass ratio of 8:1:1, solvent deionized water was added, and the mixture was stirred under a high-speed mixer until the system was uniform, whereby a negative electrode slurry was obtained. The negative electrode slurry was uniformly applied to the negative electrode current collector copper foil and dried at 85°C, and after cold pressing, the negative electrode sheet was obtained.

The electrolyte was prepared as follows: ethylene carbonate (EC), ethyl methyl carbonate (EMC), and diethyl carbonate (DEC) were mixed in a volume ratio of 20:20:60, LiPF₆ was then uniformly dissolved in the above solution, and additive fluoroethylene carbonate (FEC) was added, whereby the electrolyte was obtained. The concentration of LiPF₆ was 1 mol/L, and the mass percentage of FEC in the electrolyte was 5%.

The button cell was prepared as follows: the above negative electrode sheet was used as a working electrode, metallic lithium was used as a counter electrode, and a polypropylene film was used as a separator. The negative electrode sheet, separator, and metallic lithium were stacked in order so that the separator was positioned between the working electrode and the counter electrode. The electrolyte was injected, and the button cell was assembled.

### Preparation of secondary battery

The negative electrode sheet was prepared as follows: the negative electrode active material (which was obtained by mixing the above-prepared silicon-carbon composite material with artificial graphite in a ratio of 1:9), conductive agent carbon nanotube and SP mixture, binder styrene-butadiene rubber, and thickener carboxymethyl cellulose sodium were fully stirred and mixed in a weight ratio of 95.5:1:2:1.5 in an appropriate amount of solvent deionized water, whereby a negative electrode slurry was formed. The negative electrode slurry was applied to both surfaces of the negative electrode current collector copper foil and, after drying and cold pressing, the negative electrode sheet was obtained.

The positive electrode sheet was prepared as follows: positive electrode active material LiNi_{0.8}Co_{0.1}Mn_{0.1}O₂ (NCM811), conductive carbon black, and polyvinylidene fluoride were mixed in a weight ratio of 97.5:1.2:1.3, an appropriate amount of solvent NMP was added, and the mixture was stirred well, whereby a positive electrode slurry was obtained. The positive electrode slurry was applied to both surfaces of the positive electrode current collector aluminum foil and, after drying and cold pressing, the positive electrode sheet was obtained.

The electrolyte was prepared as follows: a mixture of ethylene carbonate (EC), ethyl methyl carbonate (EMC), and diethyl carbonate (DEC) was used as the organic solvent, with a volume ratio of EC:EMC:DEC being 20:20:60. In a glove box with water content less than 10 ppm and oxygen atmosphere, fully dried lithium salt (LiPF₆) was dissolved in the above organic solvent, and additive fluoroethylene carbonate (FEC) was added, whereby the electrolyte was obtained. In this electrolyte, a concentration of LiPF₆ was 1 mol/L, and the mass percentage of FEC in the electrolyte was 5%.

A polypropylene film was used as the separator.

The secondary battery was prepared as follows: the above-prepared positive electrode sheet, separator, and negative electrode sheet were placed in order so that the separator (that is, polypropylene film) was positioned between the positive electrode sheet and the negative electrode sheet to perform a separating function, and then they were wound to obtain the electrode assembly. The electrode assembly was placed in the outer package and dried, the outer package was filled with the above-prepared electrolyte through injection, processes are performed such as vacuum packaging, standing, formation, and capacity grading, to obtain the secondary battery.

### Performance testing of button cell

### 1. Q2/Q1 and Q3/Q1

After the above-prepared button cell was left standing for 60 min, it was discharged at a constant current of 0.05C to 5 mV, then discharged at 50 µA to 5 mV, left standing for 10 min, and charged at 0.1C to 0.8V for testing. A capacity corresponding to a voltage of 0.2 V to 0.4 V during charging was recorded as Q1, a capacity corresponding to a voltage of 0.4 V to 0.6 V was recorded as Q2, a capacity corresponding to a voltage of 0.6 V to 0.8 V was recorded as Q3, and Q2/Q1 and Q3/Q1 were calculated.

### 2. Testing of initial coulombic efficiency

After the above-assembled button cell was left standing for 60 min, it was discharged at a constant current of 0.05C to 5 mV, then discharged at 50 µA to 5 mV, left standing for 10 min, and charged at 0.1C to 0.8 V for testing. A delithiation capacity at 0.8V represented the capacity of the silicon-carbon composite material, corresponding to initial coulombic efficiency = delithiation capacity at 0.08 V / lithiation capacity.

### Performance testing of secondary battery

### Testing of cycling performance

At 25°C, the secondary battery was left standing for 30 min, then charged at 0.5C rate to 4.25 V, further charged at constant voltage of 4.25 V to a current of 0.05C, left standing for 5 min, and discharged at 0.5C rate to 2.5 V. This was one charge-discharge cycle, with the obtained capacity recorded as the initial capacity C0. The above steps were repeated for the same secondary battery, the discharge capacity Cn was recorded for each cycle, the battery capacity retention rate after each cycle was calculated as Pn = Cn/C0 * 100%, the test was stopped when Pn is less than or equal to 80%, and the number of cycles at that point was recorded.

For the button cells prepared in Example 1 to Example 4 and Comparative Example 1, Q2/Q1, Q3/Q1, and initial coulombic efficiency were tested. For the secondary batteries prepared in Example 1 to Example 4 and Comparative Example 1, cycling performance was tested, and the specific results are shown in Table 1.

**Table 1**

| No. | Total introduction amount of monosilane | Ventilation rate of mixed gas containing monosilane | Volume concentration of monosilane in tail gas | Whether a carbon coating is contained | Q2/Q1 | Q3/Q1 | Initial coulombic efficiency | Number of cycles |
|---|---|---|---|---|---|---|---|---|
| Example 1 | 780 L | 4 L/min | 4.8 vol% | Yes | 0.691 | 0.362 | 93.4% | 2539 |
| Example 2 | 720 L | 4 L/min | 2.5 vol% | Yes | 0.532 | 0.363 | 93.5% | 2890 |
| Example 3 | 780 L | 3.8 L/min | 3.7 vol% | Yes | 0.601 | 0.361 | 93.6% | 2732 |
| Example 4 | 780 L | 4 L/min | 4.7 vol% | No | 0.700 | 0.420 | 90.3% | 2545 |
| Comparative Example 1 | 780 L | 4 L/min | 5.5 vol% | Yes | 0.759 | 0.362 | 93.3% | 1946 |

As shown in Table 1, by controlling the silicon-carbon composite material to satisfy Q2/Q1 ≤ 0.7, the cycle life of the secondary battery is significantly prolonged.

### Example 5

The silicon-carbon composite material of Example 5 was prepared in a similar manner to that of Example 1, with the difference that the deposition temperature was 450°C; and when the introduction of the mixed gas of monosilane and nitrogen was stopped, the concentration of monosilane in the reaction tail gas was 3.4 vol%.

### Example 6

The silicon-carbon composite material of Example 6 was prepared in a similar manner to that of Example 1, with the difference that the deposition temperature was 520°C; and when the introduction of the mixed gas of monosilane and nitrogen was stopped, the concentration of monosilane in the reaction tail gas was 3.4 vol%.

### Example 7

The silicon-carbon composite material of Example 7 was prepared in a similar manner to that of Example 1, with the difference that the deposition temperature was 550°C; and when the introduction of the mixed gas of monosilane and nitrogen was stopped, the concentration of monosilane in the reaction tail gas was 3.4 vol%.

### Example 8

The silicon-carbon composite material of Example 8 was prepared in a similar manner to that of Example 1, with the difference that the deposition temperature was 600°C; and when the introduction of the mixed gas of monosilane and nitrogen was stopped, the concentration of monosilane in the reaction tail gas was 3.4 vol%.

For the button cells that were further prepared from the silicon-carbon composite materials prepared in Example 5 to Example 8 using the same method as above, Q2/Q1, Q3/Q1, and the initial coulombic efficiency were tested and obtained. For the secondary batteries that were further prepared from the silicon-carbon composite materials prepared in Example 5 to Example 8 using the same method as above, the cycling performance was tested and obtained. The specific results are shown in Table 2.

**Table 2**

| No. | Deposition temperature | Q2/Q1 | Q3/Q1 | Initial coulombic efficiency | Number of cycles |
|---|---|---|---|---|---|
| Example 1 | 500°C | 0.691 | 0.362 | 93.4% | 2539 |
| Example 5 | 450°C | 0.695 | 0.363 | 93.2% | 2550 |
| Example 6 | 520°C | 0.664 | 0.362 | 93.5% | 2671 |
| Example 7 | 550°C | 0.681 | 0.361 | 93.3% | 2639 |
| Example 8 | 600°C | 0.696 | 0.363 | 93.1% | 2543 |

As shown in Table 2, with changes in the deposition temperature, Q2/Q1 of the button cell prepared from the silicon-carbon composite material also changes, and the cycling performance of the secondary battery prepared from the corresponding silicon-carbon composite material also changes. Overall, the deposition temperature has an insignificant impact on the cycling performance of the secondary battery prepared from the silicon-carbon composite material.

### Example 9

The silicon-carbon composite material of Example 9 was prepared in a similar manner to that of Example 1, with the difference that the introduction amount of monosilane in the initial reaction stage was 155 L, the introduction amount of monosilane in the middle reaction stage was 470 L, and the introduction amount of monosilane in the end reaction stage was 155 L; and when the introduction of the mixed gas of monosilane and nitrogen was stopped, the concentration of monosilane in the reaction tail gas was 2.3 vol%.

### Example 10

The silicon-carbon composite material of Example 10 was prepared in a similar manner to that of Example 1, with the difference that the introduction amount of monosilane in the initial reaction stage was 170 L, the introduction amount of monosilane in the middle reaction stage was 440 L, and the introduction amount of monosilane in the end reaction stage was 170 L; and when the introduction of the mixed gas of monosilane and nitrogen was stopped, the concentration of monosilane in the reaction tail gas was 2.3 vol%.

For the button cells that were further prepared from the silicon-carbon composite materials prepared in Example 9 and Example 10 using the same method as above, the initial coulombic efficiency was tested and obtained. For the secondary batteries that were further prepared from the silicon-carbon composite materials prepared in Example 9 and Example 10 using the same method as above, the cycling performance was tested and obtained. The specific results are shown in Table 3.

**Table 3**

| No. | Introduction amount of monosilane | | | Q2/Q1 | Q3/Q1 | Initial coulombic efficiency | Number of cycles |
|---|---|---|---|---|---|---|---|
| | Initial reaction stage | Middle reaction stage | End reaction stage | | | | |
| Example 9 | 155 L | 470 L | 155 L | 0.526 | 0.363 | 93.4% | 2895 |
| Example 10 | 170 L | 440 L | 170 L | 0.537 | 0.362 | 93.5% | 2891 |

As shown in Table 3, by dividing the reaction process into an initial reaction stage, a middle reaction stage, and an end reaction stage, with changes in the introduction amount of monosilane in each reaction stage, Q2/Q1 of the button cell prepared from the silicon-carbon composite material also changes, and the cycling performance of the secondary battery prepared from the corresponding silicon-carbon composite material also changes. Overall, dividing the reaction process into three stages and controlling the introduction amount of monosilane in each reaction stage are more conducive to controlling Q2/Q1 of the button cell prepared from the silicon-carbon composite material within the optional range.

It should be noted that this disclosure is not limited to the above embodiments. The above embodiments are only examples, and embodiments having substantially the same configuration as the technical idea within the scope of the technical solution of this disclosure and achieving the same effects are included in the technical scope of this disclosure. In addition, within the scope not departing from the gist of this disclosure, various modifications that can be conceived by those skilled in the art, and other forms constructed by combining some constituent elements of the embodiments are also included in the scope of this disclosure.

## Claims

1. A silicon-carbon composite material, wherein the silicon-carbon composite material comprises: a porous carbon matrix and a silicon-based material, wherein at least part of the silicon-based material is distributed in pores of the porous carbon matrix; and
the silicon-carbon composite material satisfies Q2/Q1 ≤ 0.7, a button cell containing the silicon-carbon composite material is charged and discharged, a capacity corresponding to a voltage of 0.2 V to 0.4 V during charging is Q1, and a capacity corresponding to a voltage of 0.4 V to 0.6 V during charging is Q2.

2. The silicon-carbon composite material according to claim 1, wherein the silicon-carbon composite material satisfies 0.3 ≤ Q2/Q1 ≤ 0.7, optionally 0.5 ≤ Q2/Q1 ≤ 0.65.

3. The silicon-carbon composite material according to claim 1 or 2, wherein at least part of a surface of the silicon-carbon composite material has a coating; and optionally, a thickness of the coating is 2 nm to 100 nm.

4. The silicon-carbon composite material according to claim 3, wherein the silicon-carbon composite material satisfies Q3/Q1 ≤ 0.37; and a capacity corresponding to a voltage of 0.6 V to 0.8 V during charging is Q3.

5. The silicon-carbon composite material according to claim 4, wherein the silicon-carbon composite material satisfies 0.25 ≤ Q3/Q1 ≤ 0.37, optionally 0.3 ≤ Q3/Q1 ≤ 0.37.

6. The silicon-carbon composite material according to any one of claims 1 to 5, wherein the porous carbon matrix comprises micropores and mesopores; and optionally, a pore volume ratio of the micropores to the mesopores is 1 to 40.

7. The silicon-carbon composite material according to any one of claims 1 to 6, wherein the silicon-carbon composite material satisfies at least one of the following:
a specific surface area BET of the silicon-carbon composite material is 0.1 m²/g to 5 m²/g;
a percentage of the silicon-based material in the silicon-carbon composite material is 30% to 60%; and
at least part of the silicon-based material in the silicon-carbon composite material exists in a form of amorphous silicon.

8. A preparation method of a silicon-carbon composite material, wherein the method comprises the following steps:
introducing a gas containing silane into a reactor comprising a porous carbon matrix to deposit a silicon-based material in pores of the porous carbon matrix; and
monitoring reaction tail gas, and when a volume concentration of silane in the reaction tail gas is not higher than 5 vol%, stopping introduction of the gas containing silane to obtain the silicon-carbon composite material, wherein the silicon-carbon composite material comprises: a porous carbon matrix and a silicon-based material, wherein at least part of the silicon-based material is distributed in pores of the porous carbon matrix, the silicon-carbon composite material satisfies Q2/Q1 ≤ 0.7, a button cell containing the silicon-carbon composite material is charged and discharged, a capacity corresponding to a voltage of 0.2 V to 0.4 V during charging is Q1, and a capacity corresponding to a voltage of 0.4 V to 0.6 V during charging is Q2.

9. The preparation method according to claim 8, wherein a total volume of silane introduced into the gas containing silane per kilogram of the porous carbon matrix is 400 L to 1500 L.

10. The preparation method according to claim 8 or 9, wherein a temperature for depositing the silicon-based material is 450°C to 600°C; and/or
a deposition time per kilogram of the porous carbon matrix is 1.2 h to 37.5 h; and/or
a ventilation rate of the gas containing silane is 0.1 L/min to 10 L/min; wherein
optionally, at 510°C to 560°C, the deposition time per kilogram of the porous carbon matrix is 2.5 h to 20 h.

11. The preparation method according to any one of claims 8 to 10, wherein depositing the silicon-based material in the pores of the porous carbon matrix comprises an initial reaction stage, a middle reaction stage, and an end reaction stage, wherein based on an amount of silane introduced per kilogram of the porous carbon matrix, an amount of silane introduced in the initial reaction stage is 20 L to 170 L, an amount of silane introduced in the middle reaction stage is 390 L to 680 L, and an amount of silane introduced in the end reaction stage is 20 L to 170 L; and optionally, based on the amount of silane introduced per kilogram of the porous carbon matrix, the amount of silane introduced in the initial reaction stage is 150 L to 170 L, the amount of silane introduced in the middle reaction stage is 420 L to 490 L, and the amount of silane introduced in the end reaction stage is 150 L to 170 L.

12. The preparation method according to any one of claims 8 to 11, wherein the method further comprises:
forming a carbon coating on at least part of a surface of the silicon-carbon composite material; and
optionally, the forming a carbon coating on at least part of a surface of the silicon-carbon composite material comprises:
introducing a gas comprising a carbon source into the reactor, and reacting at 550°C to 900°C for 0.5 h to 10 h, and optionally, reacting at 600°C to 700°C for 2 h to 6 h.

13. A secondary battery, wherein the secondary battery comprises a negative electrode sheet, and the negative electrode sheet comprises the silicon-carbon composite material according to any one of claims 1 to 7, or a silicon-carbon composite material prepared by the preparation method according to any one of claims 8 to 12.

14. An electric apparatus, wherein the electric apparatus comprises the secondary battery according to claim 13.
